# EUROPÄISCHE PATENTANMELDUNG

(11) **EP 4 224 521 A1**
(43) Veröffentlichungstag der Anmeldung: **09.08.2023**
(21) Anmeldenummer: 22155438.9
(22) Anmeldetag: 07.02.2022
(51) Int. Cl.: H01L 23/485, C23C 4/08, C23C 4/123, C23C 4/134, C23C 28/02

(54) **HALBLEITERANORDNUNG MIT EINEM HALBLEITERELEMENT MIT EINEM DURCH THERMISCHES SPRITZEN HERGESTELLTEN KONTAKTIERUNGSELEMENT SOWIE EIN VERFAHREN ZUR HERSTELLUNG DESSELBEN**

(71) Anmelder: Siemens Aktiengesellschaft, 80333 München (DE); Friedrich-Alexander-Universität Erlangen-Nürnberg, 91054 Erlangen (DE)
(72) Erfinder: Hensel, Alexander, 91341 Röttenbach (DE); Stegmeier, Stefan, 81825 München (DE); Wagner, Claus Florian, 90425 Nürnberg (DE); Woiton, Michael, 90425 Nürnberg (DE)
(74) Vertreter: Siemens Patent Attorneys

(57) **Zusammenfassung**

Die Erfindung betrifft eine Halbleiteranordnung (2) aufweisend ein Halbleiterelement (4) mit zumindest einem Anschlusselement (6), wobei zumindest ein metallisches Kontaktierungselement (10), flächig mit dem zumindest einen Anschlusselement (6) des Halbleiterelements (4) verbunden ist. Um eine Lebensdauer der Halbleiteranordnung (2) zu erhöhen, wird vorgeschlagen, dass das zumindest eine metallische Kontaktierungselement (10) durch Aufsprühen auf das Halbleiterelement (4) mittels eines thermischen Spritzverfahrens hergestellt ist.

## Beschreibung

Die Erfindung betrifft eine Halbleiteranordnung aufweisend ein Halbleiterelement mit zumindest einem Anschlusselement, wobei zumindest ein metallisches Kontaktierungselement, flächig mit dem zumindest einen Anschlusselement des Halbleiterelements verbunden ist.

Ferner betrifft die Erfindung einen Stromrichter mit mindestens einer derartigen Halbleiteranordnung.

Darüber hinaus betrifft die Erfindung ein Verfahren zur Herstellung einer Halbleiteranordnung aufweisend ein Halbleiterelement mit zumindest einem Anschlusselement, wobei zumindest ein metallisches Kontaktierungselement, flächig mit dem zumindest einen Anschlusselement des Leistungshalbleiters verbunden wird.

Derartige Halbleiteranordnungen kommen beispielsweise in einem Stromrichter zum Einsatz. Unter einem Stromrichter ist beispielsweise ein Gleichrichter, ein Wechselrichter, ein Umrichter oder ein Gleichspannungswandler zu verstehen. Ein Halbleiterelement einer derartigen Halbleiteranordnung kann unter anderem als ein Transistor, insbesondere als ein Insulated-Gate-Bipolar-Transistor (IGBT), Feldeffekttransistor oder Bipolartransistor, Triac, Thyristor oder Diode ausgeführt sein. Zur Kontaktierung von Anschlusselementen derartiger Halbleiterelemente wird üblicherweise Aluminium-Wire-Bond-Technologie eingesetzt. Insbesondere in modernen Aufbau- und Verbindungstechnologien, sind derartige Bondverbindungsmittel häufig der lebensdauerbegrenzende Faktor.

Eine deutlich höhere Lebensdauer verspricht beispielsweise, insbesondere aufgrund eines höheren Elastizitätsmoduls, kurz E-Modul, und einer höheren elektrischen Leitfähigkeit, die Kupfer-Wire-Bond-Technologie. Diese erfordert jedoch höhere Druckkräfte bei der Kontaktierung, wodurch sich die Gefahr einer Beschädigung von Halbleiterelementen ergibt.

Die Offenlegungsschrift DE 10 2009 008 926 A1 betrifft ein Verfahren zur Schaffung einer hochtemperatur- und temperaturwechselfesten Verbindung eines Baugruppen-Halbleiters und eines Halbleiterbausteins mit einem temperaturbeaufschlagenden Verfahren, bei dem auf die Bereiche der später zu verbindenden einzelnen Halbleiter-Bausteine eine Metallpulversuspension aufgebracht wird, die Suspensionsschicht unter Ausgasen der flüchtigen Bestandteile und unter Erzeugung einer porösen Schicht getrocknet wird, die poröse Schicht vorverdichtet wird, ohne dass eine vollständige, die Suspensionsschicht durchdringende Versinterung stattfindet, und zur Erlangung einer festen elektrisch und thermisch gut leitenden Verbindung eines Halbleiter-Bausteins auf einem Verbindungspartner aus der Gruppe: Substrat, weiterem Halbleiter oder Schaltungsträger, die Verbindung eine ohne Pressdruck durch Temperaturerhöhung erzeugte Sinterverbindung ist, die aus einer getrockneten Metallpulversuspension besteht, die in einem Vorverdichtungsschritt mit dem Verbindungspartner einen ersten transportfesten Kontakt mit dem Verbindungspartner erfahren hat, und drucklos unter Temperaturaussinterung verfestigt wurde.

Die Verwendung derartiger gesinterter Schichten bringt den Nachteil mit sich, dass die unterschiedlichen Ausdehnungskoeffizienten der Werkstoffe, insbesondere bei thermischen Zyklen, eine hohe Belastung darstellen. Die Folge ist ein schnelles Versagen an der Grenzfläche.

Die Offenlegungsschrift EP 3 926 670 A1 beschreibt ein Leistungshalbleitermodul mit zumindest einem Leistungshalbleiterelement. Um den erforderlichen Bauraum des Leistungshalbleitermoduls zu verringern und dessen Lebensdauer zu erhöhen, wird vorgeschlagen, dass das zumindest eine Leistungshalbleiterelement über eine dielektrische Materiallage mit einem Kühlelement in einer elektrisch isolierenden und thermisch leitfähigen Verbindung steht, wobei die dielektrische Materiallage flächig auf einer Oberfläche des Kühlelements aufliegt und mittels einer orthogonal zur Oberfläche des Kühlelements wirkenden ersten Kraft kraftschlüssig mit dem Kühlelement verbunden ist.

Vor diesem Hintergrund ist es eine Aufgabe der vorliegenden Erfindung, die Lebensdauer einer Halbleiteranordnung zu erhöhen.

Diese Aufgabe wird bei einer Halbleiteranordnung eingangs genannter Art dadurch gelöst, dass das zumindest eine metallische Kontaktierungselement durch Aufsprühen auf das Halbleiterelement mittels eines thermischen Spritzverfahrens hergestellt ist.

Ferner wird die Aufgabe erfindungsgemäß gelöst durch einen Stromrichter mit mindestens einer derartigen Halbleiteranordnung.

Darüber hinaus wird die Aufgabe bei einem Verfahren eingangs genannter Art dadurch gelöst, dass das zumindest eine metallische Kontaktierungselement durch Aufsprühen auf das Halbleiterelement mittels eines thermischen Spritzverfahrens hergestellt wird.

Die in Bezug auf die Halbleiteranordnung nachstehend angeführten Vorteile und bevorzugten Ausgestaltungen lassen sich sinngemäß auf den Stromrichter und das Verfahren übertragen.

Der Erfindung liegt die Überlegung zugrunde, die Lebensdauer einer Halbleiteranordnung mit einem Halbleiterelement zu erhöhen, indem ein Kontaktierungselement, beispielsweise eine metallische Schicht, durch Aufsprühen auf das Halbleiterelement mittels eines thermischen Spritzverfahrens hergestellt wird. Ein thermisches Spritzverfahren ist ein Verfahren, bei dem Spritzzusätze, beispielsweise Partikel, auf eine Oberfläche geschleudert werden. Die Spritzzusätze können unter anderem als Stab, Draht, Suspension oder Pulver vorliegen. Diese können bis zum plastischen oder geschmolzenen Zustand aufgeheizt werden. Derartige thermische Spritzverfahren sind unter anderem atmosphärisches Plasmaspritzen (APS), Flammspritzen (FS), Hochgeschwindigkeits-Flammspritzen (HVOF/HVAF), Lichtbogendrahtspritzen (LDS) und Kaltgasspritzen (CS). Auf diese Weise wird das metallisches Kontaktierungselement, flächig mit dem zumindest einen Anschlusselement des Halbleiterelements verbunden ist. Ein derartiges Anschlusselement kann ein Kontaktpad mit einer Chipmetallisierung sein. Ein derartiges Kontaktpad kann unter anderem zur Kontaktierung des Halbleiterelements, z.B. über Bondverbindungsmittel, vorgesehen sein. Das aufgesprühte metallische Kontaktierungselement kann eine metallische Schicht ausbilden, die beispielsweise beim Kontaktieren, insbesondere beim Bonden, z.B. mittels Ultraschallbonden oder Laserschweißbonden, auftretende Druckkräfte verteilt, sodass Risse im Halbleiter vermieden werden. Die Schicht weist beispielsweise eine Dicke im Bereich von 1 µm bis 250 µm, insbesondere 5 µm bis 100 µm, auf. Durch die Verringerung der Rissbildung wird die Lebensdauer der Halbleiteranordnung erhöht. Durch das thermische Spritzverfahren und die damit entstehende Struktur weist das metallische Kontaktierungselement, insbesondere im Vergleich zu einem schmelzmetallurgisch hergestellten oder gesinterten Metallplättchen, eine höhere Porosität und eine leichte Federwirkung auf. Die erhöhte Porosität wirkt bei Druckanbindung toleranzausgleichend. Insbesondere beim späteren Betrieb des Halbleiterelements, beispielsweise beim An- und Ausschalten eines Leistungshalbleiters, sind die unterschiedlichen Ausdehnungskoeffizienten des Halbleiters und der im metallischen Kontaktierungselement verwendeten Metalle durch die leichte Federwirkung ausgleichbar. Somit kann das metallische Kontaktierungselement als Bufferschicht fungieren, was sich positiv auf die Lebensdauer der Halbleiteranordnung auswirkt.

Eine weitere Ausführungsform sieht vor, dass ein Bondverbindungsmittel, insbesondere Kupfer-Bondverbindungsmittel, oder ein Presskontakt über eine Oberfläche des metallische Kontaktierungselements mit dem Anschlusselement des Halbleiterelements kontaktiert ist. Derartige Bondverbindungsmittel können unter anderem Bonddrähte oder Bondbänder sein. Ein Presskontakt kann unter anderem als Stromschiene, welche auch Busbar genannt wird, ausgeführt sein. Durch die Struktur des mittels des thermischen Spritzverfahrens hergestellten metallischen Kontaktierungselements werden durch die Druckanbindung des Presskontakts oder Wirebonds auftretende Kräfte nivelliert, sodass eine Rissbildung verringert und damit die Lebensdauer erhöht wird.

Eine weitere Ausführungsform sieht vor, dass der Presskontakt über eine, insbesondere orthogonal zur Oberfläche des metallische Kontaktierungselements wirkende, Kraft mit dem Anschlusselement kontaktiert ist. Insbesondere ein Druckkontaktierung mittels Stromschiene ist, beispielsweise im Vergleich zu einer Bondverbindung, robuster gegen zyklischen Stress, was die Lebensdauer der Halbleiteranordnung zusätzlich vergrößert.

Eine weitere Ausführungsform sieht vor, dass das metallische Kontaktierungselement Partikel umfasst, welche eine texturierte Schicht ausbilden. Die Partikel enthalten beispielsweise Kupfer und/oder Molybdän. Eine derartige texturierte Schicht setzt sich aus Partikeln zusammen, welche zumindest teilweise durch Deformation fladenartig ausgeführt sind, wodurch auf die Schicht wirkende Druckkräfte ausgeglichen werden. Wird, beispielsweise beim Kontaktieren, insbesondere beim Bonden, Druck auf die auf dem Halbleiterelement angeordnete texturierte Schicht ausgeübt, so werden auftretende Druckkräfte nivelliert und homogen an das Halbleiterelement weitergeben, was sich positiv auf die Lebensdauer der Halbleiteranordnung auswirkt. Auch beim späteren Betrieb der Halbleiteranordnung, beispielsweise beim An- und Ausschalten eines Leistungshalbleiters, werden die unterschiedlichen Ausdehnungskoeffizienten durch die texturierte Schicht ausgleichen.

Eine weitere Ausführungsform sieht vor, dass die texturierte Schicht, insbesondere fladenartig, deformierte erste Partikel und aufgeschmolzene zweite Partikel umfasst, wobei die ersten Partikel zumindest um das Fünffache, insbesondere um das Zehnfache, größer sind als die zweiten Partikel. Die größeren ersten Partikel übernehmen aufgrund ihres Volumens einen Großteil der elektrischen Eigenschaft. Die kleineren aufgeschmolzenen zweiten Partikel, welche auch als kondensierter Metalldampf bezeichnet werden, definieren die mechanischen Eigenschaften. Durch eine derartige texturierte metallische Schicht sind CTE-Missmatches ausgleichbar und es ist eine verbesserte Kräfteverteilung erzielbar. Zudem werden durch derartige texturierte metallische Schichten auftretende Risse nicht, wie bei starren Systemen allgemein bekannt, direkt in den Halbleiter geleitet, sondern verbleiben in der texturierten metallischen Schicht. Auftretende Spannungen werden reduziert und/oder Risse laufen sich tot. Letzteres ist erreichbar, indem der E-Modul und die Streckgrenze im Vergleich zu Bulk-Kupfer (ETP-Cu) deutlich reduziert wird.

Eine weitere Ausführungsform sieht vor, dass die, insbesondere fladenartig, deformierten ersten Partikel über die aufgeschmolzenen zweiten Partikel miteinander verbunden sind. Die kleineren aufgeschmolzenen zweiten Partikel fungieren somit als Adhäsionsmittel, wodurch sie die mechanischen Eigenschaften, insbesondere ein E-Modul, eine Streckgrenze, ..., definieren. Somit wird ein Federsystem ausgebildet, in dem die kleineren aufgeschmolzenen zweiten Partikel die größeren fladenartig deformierten ersten Partikel verbinden. Dadurch sind CTE-Missmatches noch besser ausgleichbar und es ist eine weiter verbesserte Kräfteverteilung erzielbar.

Eine weitere Ausführungsform sieht vor, dass die Partikel eine Größe im Bereich 1 µm bis 100 µm, insbesondere 5 µm bis 25 µm, aufweisen und/oder mit einer Geschwindigkeit von 50 bis 800 m/s aufgesprüht sind. Durch diese Parameter wird eine gute Haftung erreicht, ohne das Halbleiterelement zu beschädigen.

Eine weitere Ausführungsform sieht vor, dass das metallische Kontaktierungselement eine Porosität im Bereich von 1 % bis 70 %, insbesondere 2 % bis 50 %, aufweist. Eine derartige Porosität des metallischen Kontaktierungselements wirkt bei Druckanbindungen toleranzausgleichend ohne dass die die Schicht mechanisch instabil wird. Dies führt zu einer Entlastung des Halbleiterelements, was sich positiv auf die Lebensdauer der Halbleiteranordnung auswirkt.

Eine weitere Ausführungsform sieht vor, dass das metallische Kontaktierungselement zusätzlich Partikel eines nichtmetallischen anorganischen Werkstoffs enthält. Ein derartiger nichtmetallischer anorganischer Werkstoff ist beispielsweise ein Metalloxid wie Aluminiumoxid, ein Metallnitrid wie Aluminiumnitrid, ein Halbleiter wie Silizium oder ein Halbleiteroxid wie Siliziumoxid. Durch eine derartige Füllung des metallischen Kontaktierungselements wird der Ausdehnungskoeffizienten des Kontaktierungselements variierbar, sodass das Halbleiterelement entlastet wird, was sich positiv auf die Lebensdauer der Halbleiteranordnung auswirkt. Im Vergleich zu einer Vergrößerung der Porosität wird eine verbesserte Wärmeleitfähigkeit erreicht.

Eine weitere Ausführungsform sieht vor, dass das Kontaktierungselement einen Materialgradienten aufweist. Ein derartiger Materialgradient ist eine ungleichmäßige Verteilung von zumindest zwei unterschiedlichen Materialien und/oder Material- bzw. Prozessparametern. Beispielsweise enthält das Kontaktierungselement Molybdän und Kupfer, wobei sich ein Anteil an Molybdän zum Halbleiterelement hin vergrößert, während sich ein Kupferanteil vom Halbleiterelement weg vergrößert, was zu einer, insbesondere stufenlosen, Verringerung des Ausdehnungskoeffizienten des Kontaktierungselements zum Halbleiterelement hinführt. Ferner ist ein Materialgradient durch Variation von Materialparametern herstellbar. Die Materialparameter sind über Prozessparameter des thermischen Spritzverfahrens, beispielsweise die Partikelgeschwindigkeit, die Partikelgröße, die Temperatur, die Atmosphäre usw., beeinflussbar. Dies führt zu ortsabhängig unterschiedlichen Eigenschaften. Beispielsweise sind unter anderem die Porosität, der Schmelzgrad, die Art der Partikelverformung, insbesondere in Abhängigkeit der Entfernung vom Halbleiterelement, durch Änderung von Prozessparametern variierbar. Eine Vergrößerung der Porosität zum Halbleiterelement hin kann diesen entlasten.

Eine weitere Ausführungsform sieht vor, dass das Halbleiterelement als vertikales Halbleiterelement ausgeführt ist, wobei zumindest zwei metallische Kontaktierungselemente auf gegenüberliegenden Seiten des vertikalen Halbleiterelements angeordnet sind. Ein vertikales Halbleiterelement kann unter anderem ein IGBT sein. Durch eine derartige Anordnung kann eine beidseitige Nivellierung erreicht werden, was die Lebensdauer zusätzlich positiv beeinflusst.

Im Folgenden wird die Erfindung anhand der in den Figuren dargestellten Ausführungsbeispiele näher beschrieben und erläutert.

Es zeigen:
- FIG 1: eine schematische Darstellung einer Halbleiteranordnung mit einem Halbleiterelement,
- FIG 2: eine schematische Darstellung eines thermischen Spritzverfahrens,
- FIG 3: eine schematische Darstellung einer typischen Verformung eines metallischen Partikels beim Auftreffen auf eine Oberfläche eines Halbleiterelements,
- FIG 4: eine REM-Aufnahme von verformten metallischen Partikeln in einer Draufsicht,
- FIG 5: eine schematische Darstellung einer mäanderförmigen Sprühbahngeometrie,
- FIG 6: eine vergrößerte schematische Darstellung einer Halbleiteranordnung mit einer texturierten Schicht,
- FIG 7: eine REM-Aufnahme einer texturierten Schicht in einer Seitenansicht,
- FIG 8: eine schematische Darstellung einer Krafteinleitung in ein Halbleiterelement über eine StandardKupferschicht,
- FIG 9: eine schematische Darstellung einer Krafteinleitung in ein Halbleiterelement über eine texturierte Schicht,
- FIG 10: eine schematische Darstellung einer Halbleiteranordnung mit einem Bondverbindungsmittel,
- FIG 11: eine schematische Darstellung einer Halbleiteranordnung mit einem Presskontakt,
- FIG 12: schematische Darstellung einer Halbleiteranordnung mit beidseitig am Halbleiterelement angeordneten Kontaktierungselementen und
- FIG 13: eine schematische Darstellung eines Stromrichters.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

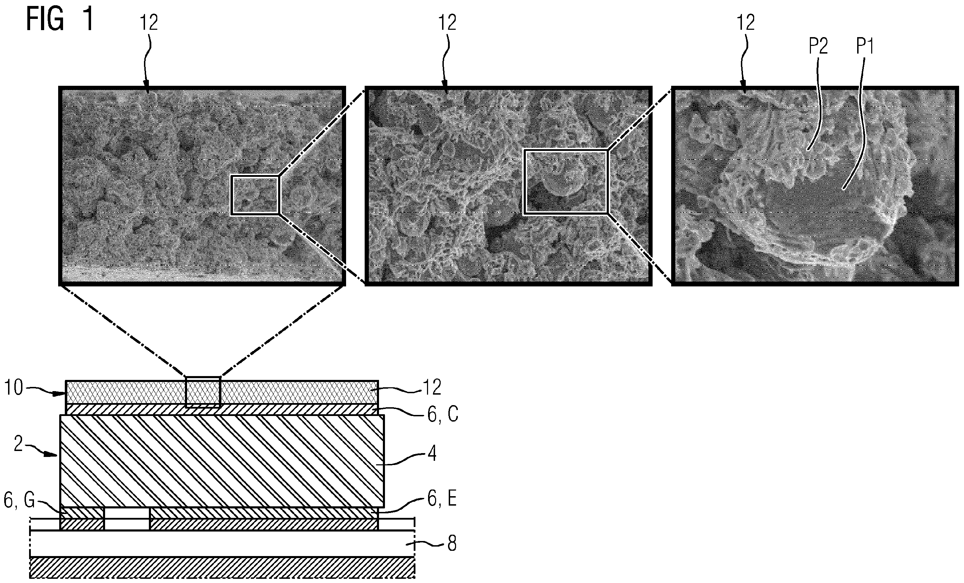

FIG 1 zeigt eine schematische Darstellung einer Halbleiteranordnung 2 mit einem Halbleiterelement 4. Das Halbleiterelement 4 ist beispielhaft als ein Insulated-Gate-BipolarTransistor (IGBT) ausgeführt. Weitere Beispiele für derartige Halbleiterelemente 4 sind andere Transistortypen wie Feldeffekttransistoren und Bipolartransistoren sowie Triacs, Thyristoren und Dioden. Das Halbleiterelement 4 kann unter Verwendung von Silizium oder eines Halbleiters mit breiter Bandlücke, z.B. Siliziumcarbid (SiC) oder Galliumnitrid (GaN), als ein Halbleitersubstrat ausgebildet sein. Der IGBT umfasst Anschlusselemente 6, welche als Gate-Anschluss G, Kollektor-Anschluss C und Emitter-Anschluss E ausgeführt sind. Die Anschlusselemente 6 umfassen jeweils ein Kontaktpad mit einer Chipmetallisierung, welche beispielsweise AlSiCu enthält. Die Kontaktpads sind zur Kontaktierung des Halbleiterelements 4, unter anderem über Bondverbindungsmittel, vorgesehen. Exemplarisch sind der Gate-Anschluss G und der Emitter-Anschluss E auf einem Substrat 8, welches unter anderem als DCB-Substrat ausgeführt sein kann, kontaktiert. Beispielsweise sind der Gate-Anschluss G und der Emitter-Anschluss E, insbesondere über eine Lötverbindung und/oder eine Sinterverbindung, stoffschlüssig mit einer strukturierten Metallisierung des Substrats 8 verbunden. Alternativ erfolgt die Verbindung mit der strukturierten Metallisierung des Substrats 8 kollektorseitig.

Auf einer dem Substrat 8 abgewandten Seite ist ein metallisches Kontaktierungselement 10 flächig mit dem Kollektor-Anschluss C des Halbleiterelements 4 verbunden. Das metallische Kontaktierungselement 10 ist durch ein thermischen Spritzverfahrens hergestellt, wobei Partikel P1, P2, welche beispielsweise Kupfer und/oder Molybdän enthalten, auf das Halbleiterelement 4 aufgesprüht sind. Durch die Partikel P1, P2 wird eine texturierte metallische Schicht 12 ausgebildet, welche beispielsweise eine Dicke im Bereich von 1 µm bis 250 µm, insbesondere 5 µm bis 100 µm, aufweist. Ein Ausschnitt der texturierten metallischen Schicht 12 ist in FIG 1 als REM-Aufnahme in verschiedenen Vergrößerungen dargestellt. Die REM-Aufnahme wurde auseinandergezogen, um deren Eigenschaften besser zu verdeutlichen. Beispielhaft ist in FIG 1 eine texturierte Kupfer- oder Molybdänschicht dargestellt. Eine derartige texturierte Schicht 12 setzt sich aus Partikeln P1, P2 zusammen, welche zumindest teilweise durch Deformation fladenartig ausgeführt sind. Beispielhaft umfasst die texturierte Schicht 12 fladenartig deformierte erste Partikel P1 und aufgeschmolzene zweite Partikel P2, wobei die ersten Partikel P1 zumindest um das Fünffache, insbesondere um das Zehnfache, größer sind als die zweiten Partikel P2. Die größeren ersten Partikel P1 übernehmen aufgrund ihres Volumens einen Großteil der elektrischen Eigenschaft. Die kleineren aufgeschmolzenen zweiten Partikel P2, welche auch als kondensierter Metalldampf bezeichnet werden, fungieren als Adhäsionsmittel und definieren somit die mechanischen Eigenschaften, insbesondere ein E-Modul, eine Streckgrenze, .... Somit wird ein Federsystem ausgebildet, in dem die kleineren aufgeschmolzenen zweiten Partikel P2 die größeren fladenartig deformierten ersten Partikel P1 verbinden. Durch eine derartige texturierte metallische Schicht 12 sind CTE-Missmatches ausgleichbar und es ist eine verbesserte Kräfteverteilung erzielbar. Zudem werden durch derartige texturierte metallische Schichten 12 auftretende Risse nicht, wie bei starren Systemen allgemein bekannt, direkt in den Halbleiter geleitet, sondern verbleiben in der texturierten metallischen Schicht 12. Auftretende Spannungen werden reduziert und/oder Risse laufen sich tot. Letzteres ist erreichbar, indem der E-Modul und die Streckgrenze im Vergleich zu Bulk-Kupfer (ETP-Cu) deutlich reduziert wird. Dies kann, insbesondere bei einer texturierten Kupfer- oder Molybdänschicht, mit einem höheren O₂-Anteil erreicht werden.

Durch derartige texturierte Schichten 12 Schichten werden Druckkräfte ausgeglichen. Wird, beispielsweise beim Kontaktieren, insbesondere beim Bonden, Druck ausgeübt, so werden auftretende Druckkräfte durch die texturierte Schichten 12 nivelliert und homogen an das Halbleiterelement 4 weitergeben. Auch beim späteren Betrieb des Halbleiterelement 4, beispielsweise beim An- und Ausschalten eines Leistungshalbleiters, werden die unterschiedlichen Ausdehnungskoeffizienten des Halbleiters (Si, GaN, SiC 3-7 ppm) und der Metalle (Kupfer 17-18 ppm, Aluminium 24 ppm) durch ihre Federwirkung stark ausgleichen. Somit fungiert das metallische Kontaktierungselement 10 als Bufferschicht. Wie aus der Literatur allgemein bekannt, neigt Kupfer erst bei höheren Temperaturen(>250°C) zu Diffusion und Korngrenzenwachstum, wodurch die beschriebene Federwirkung länger bestehen bleibt und die Eigenschaft der texturierten Schicht 12 lange im Produktleben ausnutzbar ist.

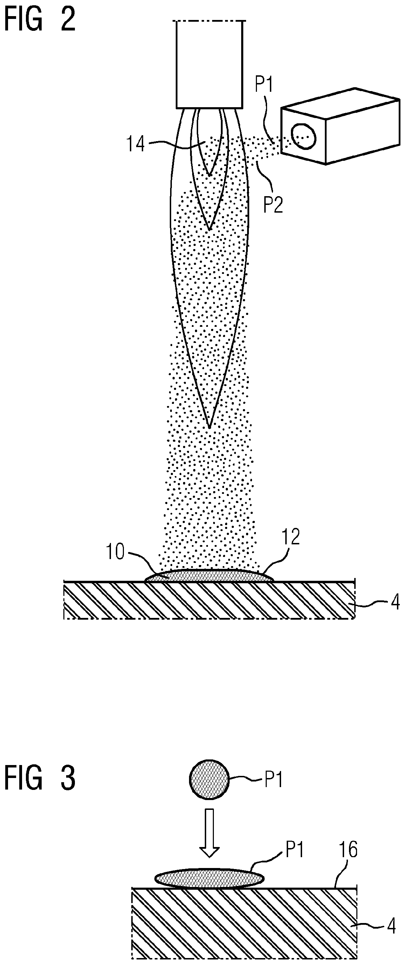

FIG 2 zeigt eine schematische Darstellung eines thermischen Spritzverfahrens, wobei durch Aufsprühen von Partikeln P1, P2 eine texturierte Schicht 12 eines metallischen Kontaktierungselements 10 auf einem Halbleiterelement 4 ausgebildet wird. Ein thermisches Spritzverfahren ist ein Verfahren, bei dem Spritzzusätze, beispielsweise Partikel, auf eine Oberfläche geschleudert werden. Die Spritzzusätze können bis zum plastischen oder geschmolzenen Zustand aufgeheizt werden. Derartige thermische Spritzverfahren sind unter anderem atmosphärisches Plasmaspritzen (APS), Flammspritzen (FS), Hochgeschwindigkeits-Flammspritzen (HVOF/HVAF), Lichtbogendrahtspritzen (LDS) und Kaltgasspritzen (CS).

Wie in FIG 2 dargestellt, formen die auftreffenden Partikel P1, P2, beispielsweise Kupferpartikel und/oder Molybdänpartikel, eine Schicht auf der Oberfläche des Halbleiterelements 4, welche, wie in FIG 1 beschrieben, sogenannten "Splats", also beim Aufprall, insbesondere fladenförmig, abgeflachte erste Partikel P1 umfasst. Zum Aufbringen der Partikel P1, P2 wird eine thermische und/oder kinetische Energiequelle 14 verwendet, welche ein Plasma, eine Verbrennungsflamme, ein Lichtbogen, ein Laser, eine Explosion oder ein erwärmtes Gas sein kann. Die Spritzzusätze unter anderem als Stab, Draht, Suspension oder Pulver vorliegen.

FIG 3 zeigt eine schematische Darstellung einer typischen Verformung eines metallischen Partikels P1 beim Auftreffen auf eine Oberfläche 16 eines Halbleiterelements 4. Der Partikel P1 wird durch seine Geschwindigkeit, welche beispielsweise im Bereich von 50 m/s bis 800 m/s liegt, und seinen erweichten Zustand stark verformt, wodurch eine fladenartige Form erreicht wird. Dieser Effekt wird Splattering-Effekt genannt und führt durch die Benetzung einer großen Oberfläche zu einer hohen Haftung.

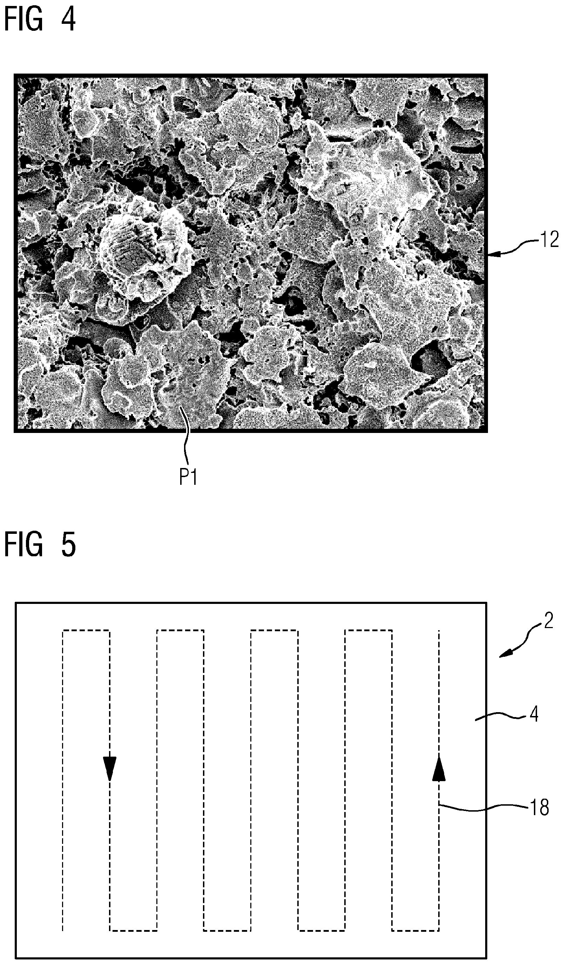

FIG 4 zeigt eine REM-Aufnahme von verformten metallischen Partikeln P1 in einer Draufsicht. Durch die fladenartig verformten metallischen Partikel P1 wird eine texturierte Schicht 12 ausgebildet, welche die in FIG 1 beschriebenen Eigenschaften aufweist.

FIG 5 zeigt eine schematische Darstellung einer mäanderförmigen Sprühbahngeometrie 18 beim Aufbringen der Partikel P1, P2 auf dem Halbleiterelement 4. Die Probe, z.B. die Halbleiteranordnung 2 wird typischerweise mittels Robotik unterhalb eines Plasmastrahls bewegt. Bei dem mäanderförmigen Sprühvorgang kommt es insbesondere zu einem Schichtüberlapp, wobei mehrere Beschichtungsübergänge gefahren werden, sodass stark texturierte Schichteigenschaften erreicht werden.

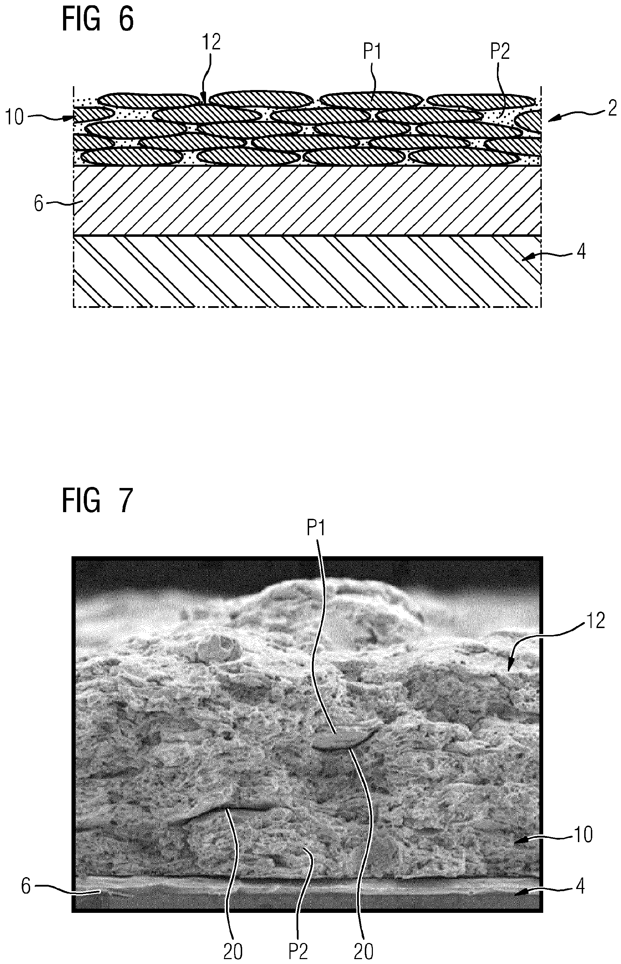

FIG 6 zeigt eine vergrößerte schematische Darstellung einer Halbleiteranordnung 2 mit einer texturierten Schicht 12, welche das mit dem Anschlusselement 6 des Halbleiterelements 4 verbundene Kontaktierungselement 10 ausbildet. Die texturierte Schicht 12 kann unter anderem Kupfer- und/oder Molybdänpartikel enthalten und umfasst fladenartig deformierte erste Partikel P1 und aufgeschmolzene zweite Partikel P2, welche auch als kondensierter Metalldampf bezeichnet werden. Wie in FIG 1 beschrieben, übernehmen die größeren ersten Partikel P1 aufgrund ihres Volumens einen Großteil der elektrischen Eigenschaften, während die kleineren aufgeschmolzenen zweiten Partikel P2, die auch als kondensierter Metalldampf bezeichnet werden, als Adhäsionsmittel fungieren. Die weitere Ausführung der Halbleiteranordnung 2 in FIG 6 entspricht der in FIG 1.

FIG 7 zeigt eine REM-Aufnahme einer texturierten Schicht 12 in einer Seitenansicht. Der texturierte Schichtaufbau führt dazu, dass entstandene Risse 20, die unter anderem durch Druck oder thermische Verspannung entstehen können, überwiegend in der Horizontalen geführt werden. Dies entlastet das sich darunter befindliche Halbleiterelement 4 erheblich. Insbesondere IGBTs und andere siliziumbasierte Halbleiterelemente 4 reagieren durch ihre typische Silizium-Orientierung, z.B. 100, sehr empfindlich ist auf vertikal eingeleitete Risse 20, welche sich im Silizium des IGBTs leicht weiterverbreiten können. Die weitere Ausführung der texturierten Schicht 12 in FIG 7 entspricht der in FIG 6.

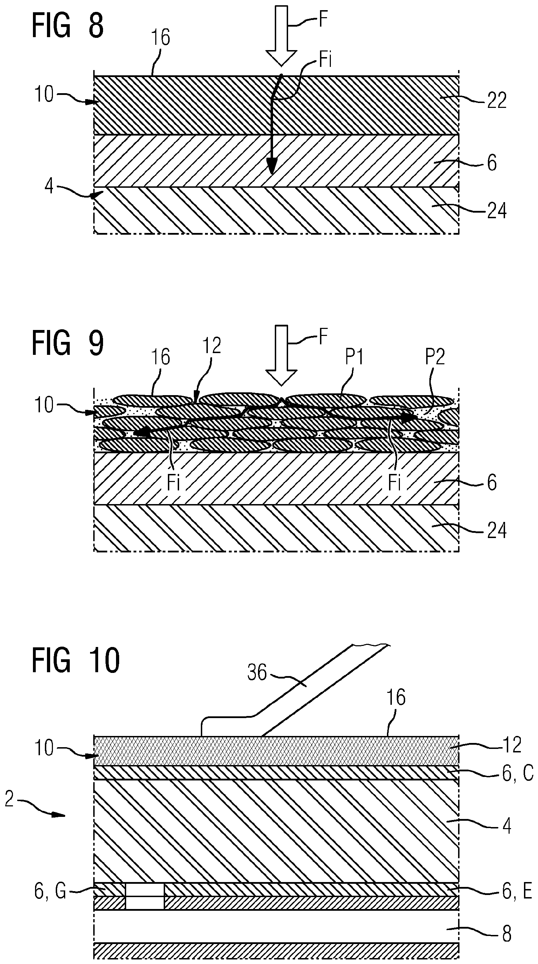

FIG 8 zeigt eine schematische Darstellung einer Krafteinleitung Fi in ein Halbleiterelement 4 über eine Standard-Kupferschicht 22 unter Einfluss einer, beispielhaft senkrecht auf die Oberfläche 16 wirkende, Kraft F. Die Kraft F wird nahezu senkrecht in das Halbleitersubstrat 24, z.B. Silizium, des Halbleiterelements 4 eingeleitet.

FIG 9 zeigt eine schematische Darstellung einer Krafteinleitung Fi in ein Halbleiterelement 4 über eine texturierte Schicht 12. Die senkrecht wirkende Kraft F wird im Wesentlichen horizontal abgeleitet. Dies führt dazu, dass die Kraft F durch die im Wesentlichen horizontale Krafteinleitung Fi verteilt bzw. der Druck homogenisiert wird, d.h. der Druck wird auf eine größere Fläche verteilt und eine Gefahr von Druckspitzen wird minimiert. Die Partikel P1, P2 können sich neu anordnen, was das Halbleiterelement 4, insbesondere das Halbleitersubstrat 24, zusätzlich entlastet.

FIG 10 zeigt eine schematische Darstellung einer Halbleiteranordnung 2 mit einem Bondverbindungsmittel 26, welches beispielsweise als Bonddraht oder Bondband ausgeführt ist. Der texturierte Schichtaufbau führt dazu, dass eine beim Bondvorgang auftretende Kraft im Wesentlichen horizontal abgeleitet wird.

Ferner weist die texturierte Schicht 12 des Kontaktierungselements 10 einen Materialgradienten, also eine ungleichmäßige Verteilung von zumindest zwei unterschiedlichen Materialien und/oder Material- bzw. Prozessparametern, auf. Beispielhaft enthält die texturierte Schicht 12 Molybdän (Mo) und Kupfer (Cu), wobei sich ein Anteil an Molybdän zum Halbleiterelement 4 hin vergrößert, während sich ein Kupferanteil vom Halbleiterelement 4 weg vergrößert. Dies führt zu einer, insbesondere stufenlosen, Verringerung des Ausdehnungskoeffizienten des Kontaktierungselements 10 zum Halbleiterelement 4 hin.

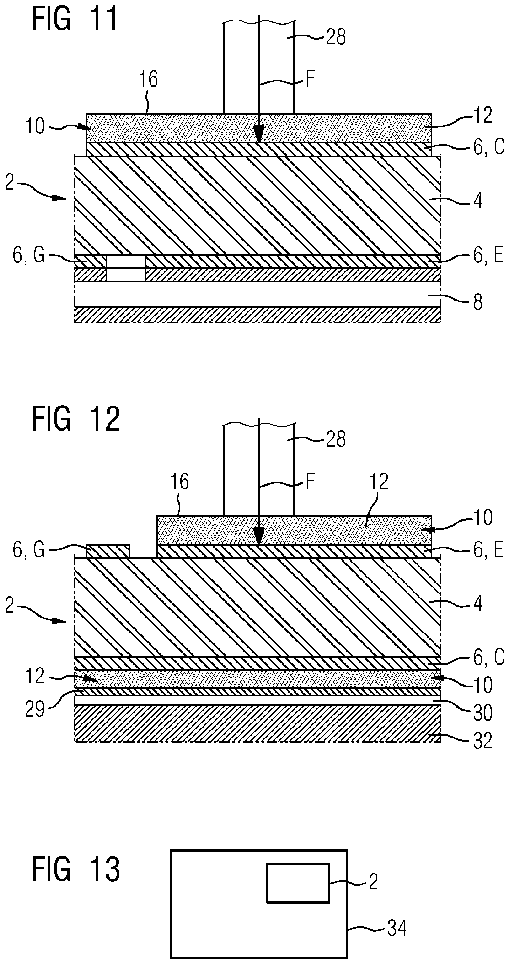

Ferner ist ein Materialgradient durch Variation von Materialparametern herstellbar. Die Materialparameter sind über Prozessparameter des thermischen Spritzverfahrens, beispielsweise die Partikelgeschwindigkeit, die Partikelgröße, die Temperatur, die Atmosphäre usw., beeinflussbar. Dies führt zu ortsabhängig unterschiedlichen Eigenschaften. Beispielsweise sind unter anderem die Porosität, der Schmelzgrad, die Art der Partikelverformung, insbesondere in Abhängigkeit der Entfernung vom Halbleiterelement 4, durch Änderung von Prozessparametern variierbar. Insbesondere sind über mehrere, insbesondere zumindest teilweise übereinander liegende, Sprühbahnen mit verschiedenen Prozessparametern derartige Eigenschaften ortsabhängig variierbar. Die weitere Ausführung der Halbleiteranordnung 2 in FIG 10 entspricht der in FIG 1. FIG 11 zeigt eine schematische Darstellung einer Halbleiteranordnung 2 mit einem Presskontakt 28. Ein derartiger Presskontakt 28 kann unter anderem eine Stromschiene, welche auch Busbar genannt wird, sein. Der Presskontakt 28 ist mittels einer orthogonal zur Oberfläche 16 des metallische Kontaktierungselements 10 wirkende Kraft F mit dem Anschlusselement 10 kontaktiert. Der texturierte Schichtaufbau des metallischen Kontaktierungselements 10 führt dazu, dass die senkrecht wirkende Kraft F im Wesentlichen horizontal abgeleitet wird. Die weitere Ausführung der Halbleiteranordnung 2 in FIG 11 entspricht der in FIG 10.

FIG 12 zeigt eine schematische Darstellung einer Halbleiteranordnung 2 mit beidseitig am Halbleiterelement 4 angeordneten metallischen Kontaktierungselementen 10, welche jeweils eine texturierte Schicht 12 aufweisen und über das thermische Spritzverfahren stoffschlüssig mit den Anschlusselementen 6 des Halbleiterelements 4 verbunden sind. Kollektorseitig ist das Halbleiterelement 4 über das metallische Kontaktierungselementen 10 mit einer Metallisierung 29 verbunden, welche über eine dielektrischen Materiallage 30 elektrisch isolierend und thermisch leitend mit einem Kühlelement 32, das beispielsweise als Kühlkörper ausgeführt ist, verbunden ist. Das Gate G kann, unter anderem über eine Bondverbindung, z.B. mit einer Treiberschaltung, verbunden werden. Die dielektrische Materiallage 30 weist einen keramischen Werkstoff, beispielsweise Aluminiumnitrid oder Aluminiumoxid, oder einen organischen Werkstoff, beispielsweise ein Polyamid, auf und liegt flächig auf dem Kühlelement 32 auf. Insbesondere liegt das Halbleiterelement 4 über das metallische Kontaktierungselementen 10 schwimmend auf der dielektrischen Materiallage 30 auf, wobei durch den Presskontakt 28 eine kraftschlüssige Verbindung hergestellt wird. Über das kollektorseitig mit dem Halbleiterelement 4 verbundene Kontaktierungselement 10 werden Kräfte zur Metallisierung 29, zur dielektrischen Materiallage 30 und zum Kühlelement 32 hin verteilt, sodass auch hier eine gute Nivellierung stattfindet.

FIG 13 zeigt eine schematische Darstellung eines Stromrichters 34, welcher beispielhaft eine Halbleiteranordnung 2 umfasst.

Zusammenfassend betrifft die Erfindung eine Halbleiteranordnung 2 aufweisend ein Halbleiterelement 4 mit zumindest einem Anschlusselement 6, wobei zumindest ein metallisches Kontaktierungselement 10, flächig mit dem zumindest einen Anschlusselement 6 des Halbleiterelements 4 verbunden ist. Um eine Lebensdauer der Halbleiteranordnung 2 zu erhöhen, wird vorgeschlagen, dass das zumindest eine metallische Kontaktierungselement 10 durch Aufsprühen auf das Halbleiterelement 4 mittels eines thermischen Spritzverfahrens hergestellt ist.

## Patentansprüche

1. Halbleiteranordnung (2) aufweisend ein Halbleiterelement (4) mit zumindest einem Anschlusselement (6),
wobei zumindest ein metallisches Kontaktierungselement (10), flächig mit dem zumindest einen Anschlusselement (6) des Halbleiterelements (4) verbunden ist,
**dadurch gekennzeichnet, dass**
das zumindest eine metallische Kontaktierungselement (10) durch Aufsprühen auf das Halbleiterelement (4) mittels eines thermischen Spritzverfahrens hergestellt ist.

2. Halbleiteranordnung (2) nach Anspruch 1,
wobei ein Bondverbindungsmittel (26), insbesondere Kupfer-Bondverbindungsmittel, oder ein Presskontakt (28) über eine Oberfläche (16) des metallische Kontaktierungselements (10) mit dem Anschlusselement (6) des Halbleiterelements (4) kontaktiert ist.

3. Halbleiteranordnung (2) nach Anspruch 2,
wobei der Presskontakt (28) über eine, insbesondere orthogonal zur Oberfläche (16) des metallische Kontaktierungselements (10) wirkende, Kraft (F) mit dem Anschlusselement (6) kontaktiert ist.

4. Halbleiteranordnung (2) nach einem der vorherigen Ansprüche,
wobei das metallische Kontaktierungselement (10) Partikel (P1, P2) umfasst, welche eine texturierte Schicht (12) ausbilden.

5. Halbleiteranordnung (2) nach Anspruch 4,
wobei die texturierte Schicht (12), insbesondere fladenartig, deformierte erste Partikel (P1) und aufgeschmolzene zweite Partikel (P2) umfasst,
wobei die ersten Partikel (P1) zumindest um das Fünffache, insbesondere um das Zehnfache, größer sind als die zweiten Partikel (P2).

6. Halbleiteranordnung (2) nach einem der Ansprüche 4 oder 5, wobei die, insbesondere fladenartig, deformierten ersten Partikel (P1) über die aufgeschmolzenen zweiten Partikel (P2) miteinander verbunden sind.

7. Halbleiteranordnung (2) nach einem der Ansprüche 4 bis 6, wobei die Partikel (P1, P2) eine Größe im Bereich von 1 µm bis 100 µm, insbesondere 5 µm-25 µm, aufweisen und/oder mit einer Geschwindigkeit von 50 bis 800 m/s aufgesprüht sind.

8. Halbleiteranordnung (2) nach einem der vorherigen Ansprüche,
wobei das metallische Kontaktierungselement (10) eine Porosität im Bereich von 1 % bis 70 %, insbesondere 2 % bis 50 %, aufweist.

9. Halbleiteranordnung (2) nach einem der vorherigen Ansprüche,
wobei das metallische Kontaktierungselement (10) zusätzlich Partikel eines nichtmetallischen anorganischen Werkstoffs enthält.

10. Halbleiteranordnung (2) nach einem der vorherigen Ansprüche,
wobei das metallische Kontaktierungselement (10) einen Materialgradienten aufweist.

11. Halbleiteranordnung (2) nach einem der vorherigen Ansprüche,
wobei das Halbleiterelement (4) als vertikales Halbleiterelement ausgeführt ist,
wobei zumindest zwei metallische Kontaktierungselemente (10) auf gegenüberliegenden Seiten des vertikalen Halbleiterelements angeordnet sind.

12. Stromrichter (34) mit mindestens einer Halbleiteranordnung (2) nach einem der vorherigen Ansprüche.

13. Verfahren zur Herstellung einer Halbleiteranordnung (2) aufweisend ein Halbleiterelement (4) mit zumindest einem Anschlusselement (6),
wobei zumindest ein metallisches Kontaktierungselement (10), flächig mit dem zumindest einen Anschlusselement (6) des Halbleiterelements (4) verbunden wird,
**dadurch gekennzeichnet, dass**
das zumindest eine metallische Kontaktierungselement (10) durch Aufsprühen auf das Halbleiterelement (4) mittels eines thermischen Spritzverfahrens hergestellt wird.

14. Verfahren nach Anspruch 13,
wobei ein Bondverbindungsmittel (26) oder ein Presskontakt (28) über eine Oberfläche (16) des metallische Kontaktierungselements (10) mit dem Anschlusselement (6) des Halbleiterelements (4) kontaktiert wird.

15. Verfahren nach Anspruch 14,
wobei der Presskontakt (28) über eine, insbesondere orthogonal zur Oberfläche (16) des metallische Kontaktierungselements (10) wirkende, Kraft (F) mit dem Anschlusselement (6) kontaktiert wird.

16. Verfahren nach einem der Ansprüche 13 bis 15,
wobei Partikel (P1, P2) aufgesprüht werden, durch welche eine texturierte Schicht (12) das metallischen Kontaktierungselements (10) ausgebildet wird.

17. Verfahren nach Anspruch 16,
wobei mittels des thermischen Spritzverfahrens ersten Partikel (P1) und zweite Partikel (P2), welche zumindest um das Fünffache, insbesondere um das Zehnfache, kleiner sind als die ersten Partikel (P1), aufgesprüht werden,
wobei die texturierte Schicht (12) durch, insbesondere fladenartiges, Deformieren der ersten Partikel (P1) und Aufschmelzen der zweiten Partikel (P2) ausgebildet wird.

18. Verfahren nach Anspruch 17,
wobei die, insbesondere fladenartig, deformierten ersten Partikel (P1) über die aufgeschmolzenen zweiten Partikel (P2) miteinander verbunden werden.

19. Verfahren nach einem der Ansprüche 16 bis 18,
wobei die Partikel (P1, P2) eine Größe von 1 µm bis 100 µm, insbesondere 5 µm-25 µm, aufweisen und/oder mit einer Geschwindigkeit von 50 bis 800 m/s aufgesprüht werden.
